# EUROPÄISCHE PATENTSCHRIFT

(11) **EP 0 294 660 B1**
(45) Veröffentlichungstag und Bekanntmachung des Hinweises auf die Patenterteilung: **04.05.1994**
(21) Anmeldenummer: 88108431.3
(22) Anmeldetag: 26.05.1988
(51) Int. Cl.: H05K 7/14

(54) **Stirnseitige Anordnung eines Moduls**
Frontal arrangement of a modul
Arrangement frontal d'un modul

(30) Priorität: 12.06.1987 DE 3719689
(43) Veröffentlichungstag der Anmeldung: 14.12.1988
(73) Patentinhaber: SCHLEICHER ELECTRONIC GMBH & CO. KG, D-85764 Oberschleissheim (DE)
(72) Erfinder: Lichtensperger, Ernst, D-8057 Eching (DE)
(74) Vertreter: Pfenning, Meinig & Partner

(56) Entgegenhaltungen:
- CH-A- 547 050
- DE-A- 3 412 593
- FR-A- 2 340 018
- US-A- 4 233 646
- US-A- 4 648 009

## Beschreibung

Die Erfindung bezieht sich auf die stirnseitge Anordnung eines Moduls mit serieller Kopplungsmöglichkeit.

Module mit serieller Kopplungsmöglichkeit für unterschiedlichste Funktionsvorgaben, werden, wie das für Zeitrelais-, Schaltschütze und andere beliebige elektrische und/oder elektronische Baugruppen bekannt ist, innerhalb abgeschlossener Gehäuseeinheiten auf Befestigungsschienen, beispielsweise Hutschienen arretiert und in der jeweils geeigneten Weise miteinander verdrahtet. Für Module der hier interessierenden Art, ist es bekannt, diese hinsichtlich der Schienenbefestigung in Flachanordnung nebeneinander auf den Schienen aufzureihen, wodurch ein nicht unerheblicher Platzbedarf bei entsprechend aufwendigen Anlagen zwingend wird. Eine stirnseitige Aneinanderreihung mit einer entsprechenden Umgestaltung des räumlichen Modulaufbaus, etwa nach Art der aus bestehenden Europanorm bekannten elektronischen Einschübe, schafft hier Abhilfe, bringt jedoch hinsichtlich der Verdrahtung, der frontseitigen Gestaltung, der nunmehr zugänglichen Stirnseite und der Arretierung jedes einzelnen Moduls innerhalb eines Gehäuse-rahmens neue Probleme.

Aus der CH-A-547050 ist ein Gestell zur Aufnahme von Leiterplatten bekannt, bei dem mit einer gesonderten Halterung eine L-förmige Griffleiste zum Einführen oder Herausziehen von Leiterplatten aus einem Gehäuse an einem Montageblock befestigt ist. Gleichzeitig kann an diesem Montageblock eine der Spaltbreite entsprechende Frontplatte für den frontseitigen Verschluß des Gehäuses angebracht werden.

Zur Befestigung von Leiterplatten ist es weiter aus US-A-4648009 bekannt, mit einem Hebelarm über ein gesondertes Verriegelungselement diese in einem Gehäuse zu befestigen und gleichzeitig die Möglichkeit zu haben, mittels des zur Verfügung stehenden Hebelarmes die Kopplung von stirnseitigen sich gegenüberstehenden Steckverbindungen zweier Leiterplatten zu erleichtern.

Die Aufgabe der Erfindung besteht darin, eine stirnseitige Anordnung von Modulen zu ermöglichen, die sowohl eine geeignete stirnseitige Anschließbarkeit der Kabelführung sicherstellt, als auch eine einfache Handhabbarkeit beim Entnehmen und Einsetzen jedes einzelnen Moduls in den Gehäuserahmen und schließlich eine Arretierung des Moduls innerhalb des Gehäuserahmens ohne zusätzliche Hilfsmittel vorzugeben in der Lage ist.

Die Lösung dieser Aufgabe wird durch die im Anspruch 1 angegebenen Merkmale erfindungsgemäß erreicht. Vorteilhafte Weiterbildungen und Ausgestaltungen dieser Aufgabenlösungen ergeben sich aus den Unteransprüchen.

Dadurch, daß wenigstens ein, vorteilhaft jedoch im Abstand zueinander zwei, von der in Einbaustellung zugänglichen und damit sichtbaren Frontseite des Moduls abstehende Winkelansätze vorgesehen werden, die mit einer Clipbefestigung in Wirkverbindung stehen, läßt sich auf einfache Weise und praktisch ohne jeden zusätzlichen Platzbedarf, sowohl die sichere Halterung und Führung für die Kabel des in diesen Bereich einzubringenden Steckers, als auch für die Montage das Einstecken und Herausziehen des Moduls aus den zugehörigen Anschlußleisten, und schließlich auch die für die Clipbefestigung erforderliche Gegenhalterung vorgeben. Es ist auch besonders vorteilhaft, die gleichzeitig als Kabelführungen dienenden Griffleisten entlang einer Längskante der Frontplatte und fluchtend zu dieser im ausreichenden Abstand zum Anschlußstecker vorzusehen, da hierdurch die ohnehin nur schmale, zur Verfügung stehende Frontseite in ihrer Flächenaufteilung nicht beeinträchtigt wird. Den oder die Winkelansätze rechtwinklig zu gestalten ist eine vorteilhafte auch optisch ansprechende Lösung, es ist jedoch auch denkbar, diese Querschnittsform parallel zur Frontseite für eine gleichfalls sichere Kabelführung abgerundet oder irgendwie kurvig zu gestalten. Die Kabelführungs- und griffbefestigungsanordnung kann insbesondere dann, wenn die Frontplatte des Moduls aus einem Kunststoff hergestellt wird integraler Bestandteil dieser Frontplatte sein, so daß für deren Herstellung keine zusätzlichen Arbeitsgänge erforderlich sind.

Die Clipbefestigung im Bereich der beiden Endkanten der Frontplatte ragt vom unteren und oberen Gehäusedeckel nur mit einem sehr kleinen Flächenquerschnitt in die Frontseite hinein, bwz. übergreift diese an beiden Enden, so daß auch hierfür praktisch kein Platzbedarf erforderlich ist. Durch die besonders vorteilhafte Formgebung der als Doppelhebel ausgebildeten Clipbefestigung sind zwei Stellungen des Clips fixiert, nämlich die des Entnahmezustandes, also der Offenstellung und jene der Schließstellung bei der das Clip in eine zugehörige Hinterschneidung an der Frontplatte des Moduls einrastet.

Weitere Vorteile und Merkmale der Erfindung sollen anhand der beigefügten Zeichnungen nachfolgend näher erläutert werden, weil diese Zeichnungen eine beispielsweise vorteilhafte Ausbildungsform der Anordnung wiedergibt.

Es zeigen:
- Fig. 1: Eine geschnittene perspektivische Teildarstellung eines Gehäuserahmens mit einem eingeschobenen und einem teilweise herausgezogenen Modul, und
- Fig. 2a und 2b: Teilschnitte durch den Clipbereich der Anordnung in Offen- und Schließstellung des Clips.

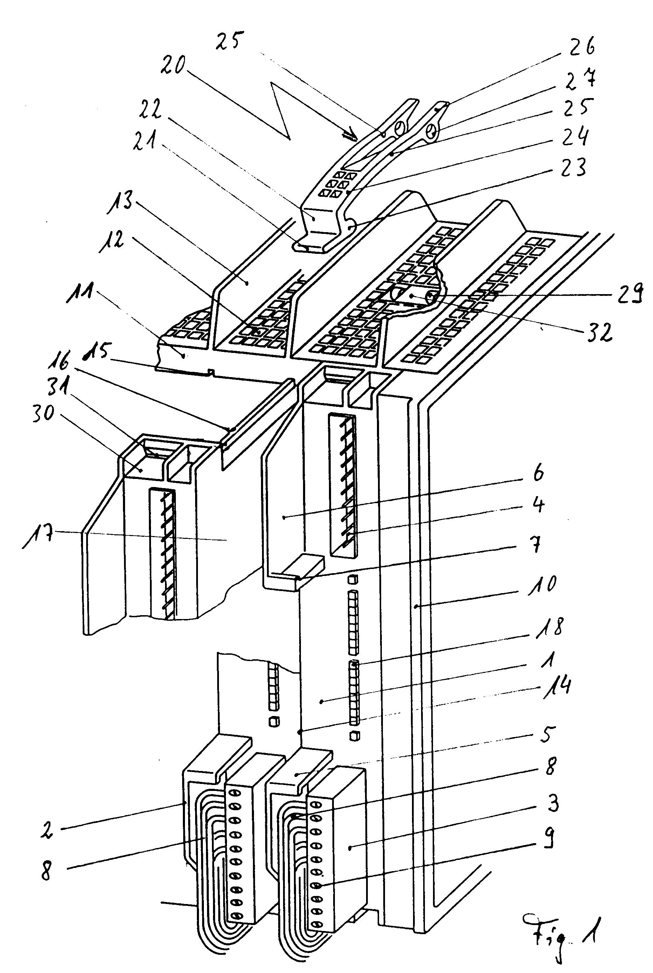

Wie aus Figur 1 ersichtlich, nimmt ein Gehäuserahmen 10 eine Mehrzahl von einzelnen Modulen auf, von denen in der Darstellung jeweils nur die Frontseite 1 sichtbar ist. Die Module werden über innerhalb des oberen und unteren Gehäusedeckels 11 eingebrachte Führungsrinnen 15 und hierin gleitende Führungsschienen 16 an den oberen und unteren Kanten der Seitenwandungen 17 eingeschoben, bzw. aus dem Gehäuserahmen herausgezogen und sind von diesen definiert gehalten.

In einer anderen Ausführungsform werden die Führungsschienen 16 durch eine die Seitenwandung 17 überragende Kante eine in dem Modul aufgenommenen Leiterplatte gebildet.

Der im Teilschnitt perspektivisch wiedergegebene Gehäusedeckel 11, ist wie der in Figur 1 nicht ersichtliche Gehäuseboden in Form eines durchbrochenen Gitters mit den Gitterdurchbrüchen 12 versehen, so daß bei senkrechter Montage der einzelnen Module innerhalb des Gehäuserahmens 10 eine gute Durchlüftung durch einen von unten nach oben gerichteten Luftstrom durch den Gehäuserahmen gewährleistet ist. Parallel im Abstand zueinander entlang des Gehäusedeckels 11 vorgesehene Rippen 13, verbessern die Stabilität und die Einbaumöglichkeit der Anordnung bei garantiert ausreichender Durchlüftung. Bei der Nebeneinanderordnung mehrerer Module liegen deren vertikale Längskanten 14,wie in der unteren Hälfte von Fig. 1 dargestellt,im dichten Abstand einander benachbart, so daß praktisch die gesamte vordere Stirnfläche des Gehäuserahmens 10 mit Moduleinschüben besetzt werden kann, ohne daß unnötiger Platz und Raum verlorengeht. Die Frontseite 1 jedes Moduls ist mit senkrecht von ihr wegstehenden entlang und fluchtend zu jeweils einer Längskante 14 liegenden Winkelansätzen versehen, die Griffleisten und Kabelführungen bilden. Im Querschnitt und zwar in einer Ebene senkrecht zur Forntseite gesehen, sind diese Winkelansätze L-förmig ausgebildet mit einem kurzen Schenkel 5 und einem langen Schenkel 6. Der kurze Schenkel 5 liegt wiederum senkrecht zu dem langen Schenkel 6 und ragt von der genannten Längskante 14 des Moduls und damit dem langen Schenkel 6 ausgehend bis nahe in die Mitte dieser stirnseitigen Frontplatte, wobei er im Abstand den Bereich einer zum langen Schenkel parallel verlaufenden Steckerbuchse auf beiden Endseiten, also oben und unten, auf der Frontseite übergreift. Jede Steckerbuchse 4, nimmt einen Anschlußstecker 3 auf, von dem aus in der dargestellten Weise ein Kabelbaum mit einer Vielzahl von Kabeln 8 abgeleitet ist, wofür der Anschlußstecker 3 selbst auf der einen Seite und der Winkelansatz 2 auf der anderen Seite eine definierte Führungsrinne vorgeben, die bis hin zum unteren Gehäusedeckel führt, innerhalb dessen Abstandshalterung dann der Kabelbaum in den hinteren Bereich des Gehäuserahmens 10 geführt werden kann. Mittels üblicher Kabelarretierungen 9 sind deren Enden innerhalb des Anschlußsteckers 3 galvanisch mit dessen Steckverbindungen verbunden. Der ansatzähnliche Vorsprung 7 an dem kurzen Schenkel 5 des Winkelansatzes 2 dient insbesondere der besseren Griffigkeit des Doppelgriffes, wofür beispielsweise Zeigefinger und Daumen auf die beiden voneinander wegzeigenden Vorsprünge 7 kurzen Schenkel 5 gedrückt werden, um ein Modul aus dem Gehäuserahmen nach Lösen der Clips 20, auf die später noch zurückgekommen werden wird, herauszuziehen bzw. in den Rahmen hineinzuschieben. Eine einwandfreie Führung der einzelnen von den Anschlußsteckern 3 jeweils abführenden Kabelbäume in den hinteren Bereich des Gehäuserahmens 10 ist zwischen den Rippen 13, von den Clipanordnungen 20 unberührt sichergestellt.

Ansonsten zeigt die Aufteilung der Frontseite 1 jedes Moduls im Ausführungsbeispiel im mittleren Bereich optische Anzeigeelemente 18, wie zum Beispiel LED-Dioden, neben denen die jeweilige Funktion für die zugehörige Betätigung in Form eines nichtdargestellten Beschriftungstableaus vorhanden sein kann.

Die optischen Anzeigeelemente können auch als Taster, Druckschalter oder dgl. ausgebildet sein.

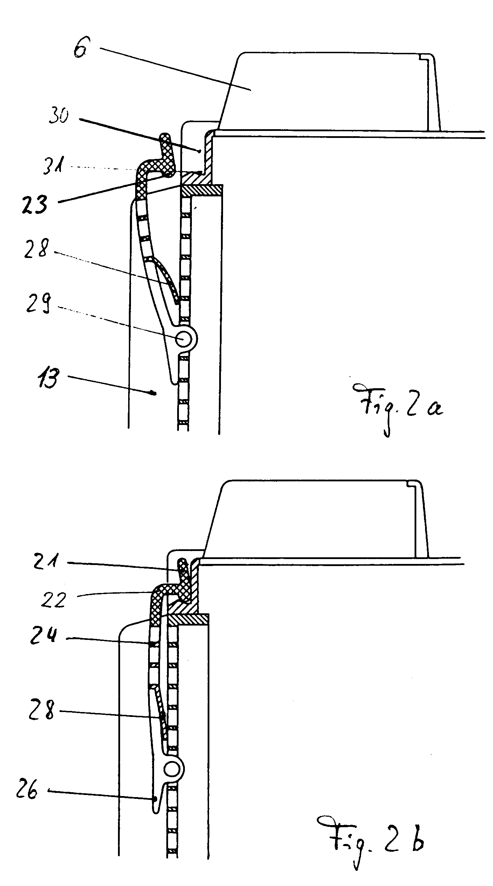

Das Clip 20 besteht im Ausführungsbeispiel aus einem Spritzgußteil aus ausreichend federndem bzw. elastisch nachgiebigem Kunststoff und stellt im wesentlichen einen Doppelhebel dar, der in Gelenkstutzen 29 innerhalb einer Scharnierbefestigung 32 eingerastet werden kann. Hierfür ist das Clip 20 in seinem in der Darstellung hinteren Teil als Schwalbenschwanzanordnung 25 ausgebildet, mit Schwenklagern 27 die durch Auseinanderdrücken der beiden Schwalbenschwänze aufeinander zu, in der Scharnierbefestigungen 32, die als Lager dienen, formschlüssig eingeschnappt werden. Der hinter dem Schwenklager 27 der Scharnierbefestigung 32 liegende jeweils V-förmig auslaufende Keil jedes Schwalbenschwanzes 25 bildet eine Schwenkbegrenzung 26 für das Clip 20, so daß dieses in Öffnungsstellung, wie in Fig. 2a dargestellt,
nur um einen definierten Winkel ausschwenken kann und hierbei über einen Federansatz 28 vorgespannt ist. Bei geeigneter Wahl des Materials für das Clip kann der Federansatz 28 integraler Bestandteil des Clips selbst sein. Der Federansatz 28 ist ein zungenartiger, zwischen der Schwalbenschwanzanordnung 25 liegender und von dieser spitzwinklig abgeführter Ansatz.

Der in der Zeichnungsdarstellung von Figur 1 vordere Teil des Clips 20 kennzeichnet sich durch das durchbrochene Mittelstück 24 an das sich weiter nach vorn die Abwinkelung 22 und an diese der Betätigungsansatz 21 anschließen zusammen mit der Arretierungsnase 23. Wie insbesondere aus den Fig. 2a und 2b ersichtlich, greift die Arretierungsnase 23 beim Eindrücken des Clips 20 gegen die Vorspannung des Federansatzes 28 in seine Schließstellung in eine Hinterschneidung 31 einer Ausnehmung 30, der Frontseite 1 des Moduls ein und bildet hier und dadurch eine kraft- und formschlüssige Arretierung. Leichter Druck gegen die Rückseite des Betätigungansatzes 21 löst die ansonsten gegen Schütteln und dergleichen mechanische Beanspruchung unempfindliche Clipverriegelung,ohne das hierfür Hilfsmittel wie Schraubenzieher oder dergleichen nötig wären.

## Patentansprüche

1. Stirnseitige Anordnung eines Moduls für Meß-, Regel-, Steuerungs- und Prozeßfunktionen aller Art, von denen eine Mehrzahl, in Nebeneinanderlage mit frontseitiger Kabelführung, innerhalb eines Gehäuserahmens unterbringbar ist,wenigstens ein von der in Einbaustellung zugänglichen sichtbaren Frontseite (1) des Moduls senkrecht abstehender Winkelansatz (2) vorgesehen ist, wobei
der/die Winkelansatz/ansätze (2) in einer Schnittfläche parallel zur Frontseite (1) gesehen, mittels zweier Schenkel (5, 6) rechtwinklig ausgebildet ist/sind und kombiniert als Griffleiste, Kabelführung und auch Befestigungshilfe dienen kann/können
und zur Befestigung des Moduls innerhalb des Gehäuserahmens eine Clipbefestigung (20), die zwei definierte Schwenkstellungen aufweist, vorhanden ist.

2. Stirnseitige Anordnung nach Anspruch 1, dadurch gekennzeichnet, daß zwei Winkelansätze (2) auf der Frontseite (1) des Moduls vorhanden sind, die entlang einer Längskante der Frontseite jeweils den Bereich der Steckerbuchsen (4) für die Anschlußstecker (3) im Abstand übergreifen.

3. Anordnung nach Anspruch 2, dadurch gekennzeichnet, daß die Winkelansätze (2) einen kurzen Schenkel (5) und einen langen schenkel (6) aufweisen.

4. Anordnung nach Anspruch 3, dadurch gekennzeichent, daS die zur Steckerbuchse (4) hinweisenden Seiten der kurzen und langen Schenkel (5, 6) Führungs- und Halterungsflächen für die Kabel (8) der Kabelzuführung zu den Anschlußsteckern (3) bilden.

5. Anordnung nach Anspruch 4, dadurch gekennzeichent, daß die kurzen Schenkel (5) des bzw. jedes Winkelansatzes (2) senkrecht von den Längskanten (14) des Moduls zur Mitte der Frontseite (1) hingeführt sind, und die Griffleisten für die Herausnahme bzw. das Einfügen des Moduls in den Gehäuserahmen (10) vorgeben.

6. Anordnung nach einem der Ansprüche 1 bis 5, dadurch gekennzeichnet, daß die langen Schenkel (6) jedes Winkelansatzes (2) fluchtend zu jeweils einer der Längskanten (14) des Moduls liegen.

7. Anordnung nach einem der Ansprüche 1 bis 6, dadurch gekennzeichnet, daß der kurze Schenkel (5) des Winkelansatzes (2) die Gegenhalterung für die Clipbefestigung (20) bildet.

8. Anordnung nach Anspruch 1, dadurch gekennzeichnet, daß die Clipbefestigung (20),in Form eines Doppelhebels ausgebildet ist mit einem Schwenklager (27), die in eine Scharnierbefestigung (32) innerhalb des Gehäusedeckels (11) einrastbar ist.

9. Anordnung nach Anspruch 7 und 8, dadurch gekennzeichnet, daß die Scharnierbefestigung (32) des Clips (20) zwei Schwenklager (27) innerhalb einer Schwalbenschwanzanordnung (25) aufweist, die in Gelenkstutzen (29) der Scharnierbefestigung (32) einschnappbar sind.

10. Anordnung nach Anspruch 9, dadurch gekennzeichnet, daß das Clip (20) zwischen der Schwalbenschwanzanordnung (25), im spitzen Winkel von dieser auf den Gehäusedeckel (11) zuweisend, einen federnden Ansatz (28) nach Art einer Zungenfeder aufweist.

11. Anordnung nach Anspruch 10, dadurch gekennzeichnet, daß das Clip (20) auf der der Schwalbenschwanzanordnung (25) gegenüberliegendne Seite, hinter einer Abwinkelung (22) einen Betätigungsansatz (21) aufweist, mit einer Arretierungsnase (23).

12. Anordnung nach wenigstens einem der Ansprüche 1 bis 6, dadurch gekennzeichnet, daß die Arretierungsnase (23) des Clips (20) in Befestigungsstellung des Moduls innerhalb einer Ausnehmung (30) in eine Hinterschneidung (31) in der Frontseite (1) eingreift.

13. Anordnung nach Anspruch 7, dadurch gekennzeichnet, daß die die Frontseite (1) bildende stirnseitige Abdeckplatte des Moduls zusammen mit den Winkelansätzen (2) eine integrale Einheit bildend ein Spritzgußteil ist.

14. Anordnung nach mindestens einem der Ansprüche 7 bis 13, dadurch gekennzeichnet, daß das Clip (20) ein hinlänglich elastisch verformbares Spritzgußteil ist.

15. Anordnung nach wenigstens einem der Ansprüche 1 bis 6, dadurch gekennzeichnet, daß das dem kurzen Schenkel (5) entfernt liegende Ende des langen Schenkels (6) an der Stirnseite im Bereich der Ausnehmung (30) endet.

## Claims

1. Frontal arrangement of a module for measuring, adjustment, control and process functions of all kinds of which a number can be accommodated side by side inside a housing frame with frontal cable routing, at least one angular shoulder being provided that projects vertically from the visible front(1) of the module that is accessible in the fitted position, characterised in that the angular shoulder (s) (2)which comprise or comprises two legs (5,6)at right angles looking along a cut edge parallel to the front (1) and can serve combined to form handle, cable routing and fixing aid and a clip (2) that has two defined pivoting positions for securing the module within the housing frame.

2. Frontal arrangement according to Claim 1 characterised in that two angular shoulders (2) are located on the front (1) of the module and overlap respectively at intervals along a longitudinal edge of the front the region of the connector sockets (4) for the connector plugs (3).

3. Arrangement according to Claim 2 characterised in that the angular shoulders (2) have a short leg (5) and a long leg (6).

4. Arrangement according to claim 3 characterised in that the sides of the short and long legs (5,6) facing the connector socket (4) form guide and retaining surfaces for the cables (8) of the cable lead to the connector plugs.

5. Arrangement according to claim 4 characterised in that the short legs (5) of the/each angular shoulder (2) are arranged perpendicular from the longitudinal edges (14) of the module to the middle of the front (1) and from the handles for withdrawing or inserting the module in the housing frame (10).

6. Arrangement according to one of claims 1 to 5 characterised in that the long legs (6) of each angular shoulder (2) are flush with one of the longitudinal edges (14) of the module respectively.

7. Arrangement according to one of claims 1 to 6 characterised in that the short leg (6) of the angular shoulder (2) forms the counter holding device for the clip (20).

8. Arrangement according to claim 1 characterised in that the clip (20) takes the form of an articulated lever with a drag bearing (27) which can be engaged in a hinged fixing (32) within the housing cover (11).

9. Arrangement according to claims 7 and 8 characterised in that the hinged fixing (32) of the clip (20) has two drag bearings (27) within a dovetail arrangement (25) which bearings can be snapped into articulated connections (29) of the hinged fixing (32).

10. Arrangement according to claim 9 characterised in that the clip (20) has an elastic shoulder (28) rather like a reed spring between the dovetail arrangement (25) pointing at an acute angle from this arrangement to the housing cover (11).

11. Arranagement according to claim 10 characterised in that the clip (20) has an actuation projection (21), with a lock lug, on the side opposite the dovetail arrangement (25) beneath a bend (22).

12. Arrangement according to at least one of the claims 1 to 6 characterised in that the lock lug (23) of the clip (20) engages in the position in which the module is secured within a recess (30) into an undercut (31) in the front (1).

13. Arrangement according to claim 7 characterised in that the cover plate of the module that forms the front (1) is a die-cast component that forms an integral unit together with the angular shoulders (2).

14. Arrangement according to at least one of claims 7 to 13 characterised in that the clip (20) is a die-cast component that can be sufficiently elastically deformed.

15. Arrangement according to at least one of the claims 1 to 6 characterised in that the end of the long leg (6) that is at a distance from the short leg (5) ends at the front in the region of the recess (30).

## Revendications

1. Arrangement frontal d'un module pour fonctions de mesure, de régulation, de commande et de traitements, de tous types, dont plusieurs peuvent être logées à l'intérieur du bâti d'un coffret, les passages de câbles étant juxtaposés du côté frontal, avec au moins un épaulement en équerre (2) faisant saillie perpendiculairement sur la face frontale visible (1) du module accessible en position de montage, ce ou ces épaulements en équerre (2), vus suivant un plan de coupe parallèle à la face frontale (1), étant configurés en équerre au moyen de deux ailes (5, 6) et pouvant servir, en combinaison, de prises de préhension, de passage de câbles et également d'accessoires de fixation, et présentant, pour la fixation dudit module à l'intérieur du bâti du coffret, une fixation à clip (20) qui présente deux positions de pivotement définies.

2. Arrangement frontal selon la revendication 1, caractérisé en ce que sur la face frontale (1) du module se trouvent deux épaulements (2) dont chacun vient recouvrir, le long d'une arête longitudinale de la face frontale, la zone des prises enfichables (4) destinées aux broches de connexion (3).

3. Arrangement selon la revendication 2, caractérisé en ce que les épaulements (2) présentent une aile courte (5) et une aile longue (6).

4. Arrangement selon la revendication 3, caractérisé en ce que les côtés des ailes courtes et longues (5, 6) orientés vers les prises enfichables (4) forment des plans de guidage et de maintien pour les câbles (8) du passage de câbles conduisant aux broches de connexion (3).

5. Arrangement selon la revendication 4, caractérisé en ce que les ailes courtes (5) du ou de chacun des épaulements (2) se dirigent, perpendiculairement aux arêtes longitudinales (14) du module, vers le milieu de la face frontale (1) et définissent les prises de préhension pour l'extraction ou l'insertion du module dans le bâti (10).

6. Arrangement selon l'une des revendications 1 à 5, caractérisé en ce que les ailes longues (6) de chaque épaulement sont alignées respectivement sur l'une des arêtes longitudinales (14) du module.

7. Arrangement selon l'une des revendications 1 à 6, caractérisé en ce que l'aile courte (5) de l'épaulement (2) constitue le contre-appui de la fixation à clip (20).

8. Arrangement selon la revendication 1, caractérisé en ce que la fixation à clip (20) est réalisée sous la forme d'un levier double comportant un appui pivotant (27) qui peut être encastré dans une fixation à charnière (32) à l'intérieur du couvercle (11) du coffret.

9. Arrangement selon les revendications 7 et 8, caractérisé en ce que la fixation à charnière (32) du clip (20) présente deux appuis pivotants (27) à l'intérieur d'un montage en queue d'aronde (25), lequel est encliquetable dans des raccords articulés (29) de la fixation à charnière (32).

10. Arrangement selon la revendication 9, caractérisé en ce que le clip (20) présente, entre le montage en queue d'aronde (25), un prolongement élastique (28) du type ressort à languette, dirigé, en formant un angle aigu, à partir dudit montage (25) vers le couvercle (11) du coffret.

11. Arrangement selon la revendication 10, caractérisé en ce que le clip (20) présente, sur le côté opposé au montage en queue d'aronde (25) derrière un angle (22), un prolongement manoeuvrable (21) muni d'un ergot d'arrêt (23).

12. Arrangement selon l'une des revendications 1 à 6, caractérisé en ce que l'ergot d'arrét (23) du clip (20) pénètre, dans la position de fixation du module, à l'intérieur d'une encoche (30) pratiquée dans une contre-dépouille (31) de la face frontale (1).

13. Arrangement selon la revendication 7, caractérisé en ce que la plaque de recouvrement du module formant, vers l'avant, la face fronale (1), est une pièce moulée par injection qui constitue une unité d'une seule pièce avec les épaulements (2).

14. Arrangement selon l'une des revendications 7 à 13, caractérisé en ce que le clip (20) est une pièce moulée par injection élastiquement déformable dans le sens de la longueur.

15. Arrangement selon l'une des revendications 1 à 6, caractérisé en ce que l'extrémité de l'aile longue (6) la plus éloignée de l'aile courte (5) vient se terminer sur la face frontale au voisinage de l'encoche (30).
